**Europäisches Patentamt**

**European Patent Office**

**Office européen des brevets**

(19)

(11) Veröffentlichungsnummer : **0 453 454 B1**

(12) **EUROPÄISCHE PATENTSCHRIFT**

(45) Veröffentlichungstag der Patentschrift :
07.09.94 Patentblatt 94/36

(51) Int. Cl.⁵ : **G01R 33/38,** G01R 33/42,
**H01F 7/22**

(21) Anmeldenummer : **90901549.7**

(22) Anmeldetag : **10.01.90**

(86) Internationale Anmeldenummer :
**PCT/DE90/00008**

(87) Internationale Veröffentlichungsnummer :
**WO 90/08329 26.07.90 Gazette 90/17**

(54) **SUPRALEITENDE MAGNETANORDNUNG.**

(30) Priorität : **12.01.89 DE 3900725**

(43) Veröffentlichungstag der Anmeldung :
**30.10.91 Patentblatt 91/44**

(45) Bekanntmachung des Hinweises auf die
Patenterteilung :
**07.09.94 Patentblatt 94/36**

(84) Benannte Vertragsstaaten :
**FR GB NL**

(56) Entgegenhaltungen :
**EP-A- 0 111 218**
**EP-A- 0 138 270**
**EP-A- 0 216 590**
**EP-A- 0 288 835**
**EP-A- 0 293 723**
**EP-A- 0 317 853**

(56) Entgegenhaltungen :
**GB-A- 2 199 147**
**Journal of Physics E: Scientific Instruments,**
**volume 19, 1986, The Institute of Physics,**
**(London, GB), P. Mansfield et al.: "Active ma-**
**gnetic screening of coils for static and time-**
**dependent magnetic field generation in NMR**
**imaging", pages 540-545**

(73) Patentinhaber : **Bruker Analytische**
**Messtechnik GmbH**
**Silberstreifen**
**D-76287 Rheinstetten (DE)**

(72) Erfinder : **WESTPHAL, Michael**
**Trifelsstrasse 22**
**D-6745 Offenbach (DE)**

(74) Vertreter : **KOHLER SCHMID + PARTNER**
**Patentanwälte**
**Ruppmannstrasse 27**
**D-70565 Stuttgart (DE)**

## Beschreibung

Die Erfindung betrifft eine supraleitende Magnetanordnung, insbesondere für Kernspin-Tomographiegeräte, mit einer aus supraleitendem Draht und einem Trägerrohr bestehenden, im wesentlichen zylindrischen Magnetspule, mit einem zur Magnetspule koaxialen Kryostat, der aus einer Anzahl von zur Magnetspule koaxialen, innerhalb und außerhalb der Magnetspule angeordneten metallischen Rohren besteht, von denen wenigstens einige paarweise durch Endwände miteinander verbunden sind, wobei das äußerste und das innerste Rohr Bestandteile eines äußeren Mantels sind, und wobei die der Magnetspule benachbarten Rohre die Wandungen eines die Magnetspule umschließenden Heliumtankes bilden und die übrigen Rohre zwischen den Wandungen des Heliumtankes und den Rohren des Mantels angeordnete Strahlungsschilde sind und gegebenenfalls die Wandungen eines die Magnetspule umgebenden Stickstofftankes bilden, mit innerhalb des innersten Rohres angeordneten Gradientenspulen, mittels derer für die Tomographie geeignete, zeitlich veränderbare Feldgradienten erzeugbar sind, und mit einem zwischen dem innersten Rohr und der Magnetspule angeordneten zylindrischen, der Abschirmung der Gradientenfelder nach außen dienenden Abschirmkörper, dessen dem Produkt aus seiner elektrischen Leitfähigkeit und seiner Wandstärke gleiche elektrische Leitzahl erheblich größer ist als die Leitzahl der weiter außen liegenden Rohre.

Eine solche Anordnung mit einem supraleitfähigen Abschirmkörper ist aus der EP-A2-0 293 723 bekannt. Die supraleitende Abschirmung ist auf einem Strahlungsschild aufgebracht. Der thermische Strahlungsschild ist gleichzeitig auch der Gradientenschirm. Dieser Schild hat im allgemeinen eine Temperatur zwischen 20K und 80K.

Weiter ist aus der EP-A-0 138 270 eine supraleitende NMR-Magnetanordnung bekannt, bei der die supraleitende Abschirmung für das magnetische Grundfeld in den Heliumtank für die supraleitenden Grundfeldspulen integriert ist. Der induktiv angekoppelte, supraleitende Abschirmkörper für das magnetische Gleichfeld kann danach entweder als durchgehender Zylinder oder als Spulensystem ausgebildet sein.

Eine Magnetanordnung der eingangs genannten Art ist auch aus IEEE-Transactions on Magnetics, Vol. 23, 2 (1987), Seite 1287, bekannt. Bei dieser bekannten Anordnung ist der innere Strahlungsschild als Abschirmkörper ausgebildet. Dieser Strahlungsschild wird im Betrieb auf der Temperatur flüssigen Stickstoffes gehalten. Bei dieser Temperatur von 77 K unterscheidet sich die elektrische Leitfähigkeit dieses Strahlungsschildes noch nicht wesentlich von der elektrischen Leitfähigkeit der anderen metallischen Strukturen des Kryostaten, so daß sich die gewünschte große Leitzahl nur durch die Ausbildung des Strahlungsschildes mit sehr großer Wandstärke erzielen läßt. Eine sehr große Wandstärke führt jedoch zu Störungen, die den Störungen gleichartig sind, welche durch die Anwendung eines solchen Abschirmkörpers vermieden werden sollen. Es handelt sich dabei um Störungen, die bei der Anwendung solcher Magnetanordnungen in Kernspin-Tomographiegeräten durch die magnetischen Felder hervorgerufen werden, welche durch das Schalten von Gradientenfeldern in der metallischen Struktur des Kryostaten und auch in der Magnetspule selbst induziert werden.

Es sind viele Anstrengungen gemacht worden, um die Störeffekte zu vermeiden, welche auf die beim Schalten von Gradientenfeldern induzierten Wirbelströme zurückgehen. So ist es beispielsweise aus der EP-A-01 64 199 bekannt, den zeitlichen Verlauf der Ströme in den Gradientenspulen des Tomographiegerätes so zu gestalten, daß der gesamte Feldgradient, der sich durch Überlagerung des von der Gradientenspule allein erzeugten Feldes sowie des von den Wirbelströmen erzeugten Störfeldes ergibt, den gewünschten zeitlichen Verlauf hat. Eine vollständige Kompensation der durch die Wirbelströme bedingten Störfelder ist jedoch in der Praxis nicht möglich, weil die in den einzelnen Rohren des Kryostaten induzierten Wirbelströme Störfeldkomponenten unterschiedlicher Stärke und unterschiedlicher Zeitkonstante liefern, so daß der Zeitverlauf für den Feldgradienten extrem kompliziert und deshalb nicht mit der erforderlichen Präzision kompensierbar ist. Diese Methode wäre nur dann erfolgreich, wenn das Störfeld mit einer einzigen, definierten Zeitkonstante abklingen würde. Dies ist jedoch bei den bekannten Magnetanordnungen nicht der Fall.

Eine weitere, aus EP 02 16 590 A1 bekannte Kompensations-Methode besteht darin, daß jede Gradientenspule von einer Abschirmspule umschlossen wird, die von dem gleichen Strom durchflossen wird wie die Gradientenspule, deren Wirkung jedoch der Gradientenspule entgegengesetzt gerichtet ist, so daß das Feld der Gradientenspule nach außen abgeschirmt wird und in den umgebenden Metallstrukturen keine Wirbelströme induziert werden. Der Nachteil einer solchen Kompensation besteht darin, daß auch das erwünschte Feld im Inneren der Gradientenspule durch das Feld der Abschirmspule geschwächt wird, so daß die Gradientenspule entsprechend stärker ausgelegt werden muß. Außerdem nimmt die Abschirmspule zusätzlichen Platz in Anspruch. Daher muß bei einem Tomographiegerät der Durchmesser der Raumtemperaturöffnung der supraleitenden Magnetanordnung zur Unterbringung eines abgeschirmten Gradientenspulensystems erheblich vergrößert werden, wenn der zur Aufnahme eines Patienten notwendige Innendurchmesser des Gradientenspulensystems beibehalten werden soll. Da die Herstellungskosten eines supraleitenden Magnetsystems sehr stark mit wachsendem Durchmesser zunehmen, ist diese Lösung des Wirbelstromproblems außerordentlich kostspielig und daher in der Praxis kaum anwendbar.

Aus GB 21 99 147 A ist es weiterhin bekannt, die Strahlungsschilde des Kryostaten in ihrer Längsrichtung zu schlitzen, so daß Wirbelströme in diesen Strahlungsschilden weitgehend vermieden werden, jedoch enthält der Kryostat Strukturen, die nicht ohne weiteres geschlitzt werden können, wie insbesondere die Wandungen des Heliumtankes und des gewöhnlich vorhandenen Stickstofftankes sowie auch das Trägerrohr der Magnetspule. Daher wird durch diese Maßnahme allenfalls eine relativ geringfügige, quantitative Reduzierung des durch die Induktion von Wirbelströmen hervorgerufenen Problems erzielt, nicht aber dessen Lösung.

Die eingangs beschriebene Anordnung eines Abschirmkörpers mit hoher elektrischer Leitzahl könnte zwar zu einer Lösung des Problems führen, jedoch verhält sich ein Rohr mit der zum Erzielen der notwendigen Leitzahl erforderlichen Dicke wie eine Anzahl ineinander geschachtelter dünnwandiger Rohre, die mit eigenen, unterschiedlichen Zeitkonstanten behaftete Wirbelströme führen, deren Kompensation durch eine entsprechende Gestaltung des zeitlichen Verlaufes der Ströme in den Gradientenspulen ebenso wenig möglich ist wie bei Kryostaten, die einen solchen Abschirmkörper nicht aufweisen.

Endlich ist es auch noch aus J. Phys. E.: Sci. Instrum. 19 (1986), Seite 876, bekannt, den inneren stickstoffgekühlten Strahlungsschild des Kryostaten besonders gut leitfähig und außerdem so dickwandig auszubilden, daß die elektromagnetische Eindringtiefe für die kleinste, den Gradienten-Zeit-Verlauf kennzeichnende Frequenz kleiner ist als die Dicke des Strahlungsschildes. In der Regel enthält jedoch der Zeit-Verlauf typischer Gradienten derart niederfrequente Komponenten, daß sich diese Forderung nicht realisieren läßt. Außerdem tritt bei sehr dickwandigen Rohren wiederum der Effekt auf, daß sich solche Rohre wie ein System von mehreren ineinander geschachtelten dünnwandigen Rohren verhält.

Demgemäß liegt der Erfindung die Aufgabe zugrunde, eine supraleitende Magnetanordnung der eingangs beschriebenen Art derart weiterzubilden, daß die Störungen, die sich aus den beim Gradientenschalten in der Struktur der Magnetanordnung induzierten Wirbelströmen ergeben, vollkommen vermieden werden, ohne daß dadurch der Aufbau der Magnetanordnung in einer für die Praxis untragbaren Weise kompliziert oder vergrößert wird.

Diese Aufgabe wird nach der Erfindung (in der Anspruchfassung für die Staaten FR und NL) dadurch gelöst, daß der Abschirmkörper in engem thermischen Kontakt mit dem Heliumtank angeordnet ist, daß dieser Körper aus einem elektrisch sehr gut leitenden Material mit einer Wandstärke von höchstens 10 mm besteht, und daß alle anderen Rohre der Magnetanordnung innerhalb und außerhalb des Abschirmkörpers aus einem im Vergleich mit der elektrischen Leitfähigkeit des Abschirmkörpers elektrisch schlecht leitendem Material bestehen, derart, daß bei Betriebstemperatur der Magnetanordnung die Leitzahl des Abschirmkörpers wenigstens das Zehnfache der Leitzahlen sowohl der außerhalb als auch der innerhalb des Abschirmkörpers liegenden Rohre beträgt.

Aus der (mit Benennung DE und GB) nachveröffentlichten EP-A-0 317 853 ist eine magnetische Einrichtung einer Anlage zur Kernspintomographie mit supraleitenden, von einem kryogenen Medium gekühlten Spulen zur Erzeugung eines homogenen magnetischen Grundfeldes, mit normalleitenden Spulen innerhalb des von den Grundfeldspulen umgrenzten Innenraumes zur Ausbildung magnetischer Feldgradienten sowie mit mindestens einem gekühlten Strahlungsschild aus elektrisch und thermisch leitendem Material, der zwischen den normalleitenden Gradientenspulen und den supraleitenden Grundfeldspulen angeordnet ist, bekannt, bei der auf der dem Innenraum zugewandten Seite der Grundfeldspulen eine rohrförmige Abschirmstruktur angeordnet ist, die supraleitendes Material zweiter Art zumindest enthält und thermisch an das kryogene Medium der Grundfeldspulen angekoppelt ist, wobei der Strahlungsschild zur Unterdrückung von in ihm zumindest durch die Gradientenspulen induzierten Wirbelströmen ausgestaltet ist. In der Druckschrift ist aber weder ein bei Betriebstemperatur resistiver Abschirmkörper noch ein solcher aus einem Gewebe aus supraleitenden Fasern oder aus einem dünnen Blech aus einer supraleitenden Legierung, das eine Gitterstruktur aufweist, offenbart.

Die im vorletzten Absatz genannten Bedingungen lassen sich beispielsweise dadurch erfüllen, daß der Abschirmkörper aus hochreinem Aluminium besteht und unmittelbar neben der Innenwand des Heliumtankes angeordnet ist, so daß seine Betriebstemperatur weniger als 10 K beträgt. Er hat dann eine Leitfähigkeit von mehr als $10^9$ Siemens/m. Dies führt bei einer Wandstärke von 10 mm zu einer Leitzahl von mehr als $10^7$ Siemens. Dagegen können die anderen Rohre der Magnetanordnung aus unmagnetischem Stahl bestehen, dessen elektrische Leitfähigkeit kleiner ist als $10^7$ Siemens/m. Da die Wandstärke solcher Rohre gewöhnlich geringer ist als 10 mm, ist die Leitzahl dieser Strukturen kleiner als $10^5$ Siemens. Unter diesen Bedingungen tritt nur noch das von den im Abschirmkörper induzierten Wirbelströmen erzeugte Feld in Erscheinung, weil die von den außerhalb des Abschirmkörpers liegenden Rohren erzeugten Felder wirksam abgeschirmt werden und andererseits die von den innerhalb des Abschirmkörpers liegenden Rohren erzeugten Felder wegen der geringen Leitfähigkeit dieser Rohre so schnell abklingen, daß sie ebenfalls vernachlässigt werden können. Diese Felder lassen sich praktisch sogar ganz unterdrücken, wenn die innerhalb des Abschirmkörpers angeordneten Rohre in ihrer Längsrichtung geschlitzt sind, was bei den innerhalb des Abschirmkörpers liegenden Strahlungsschilden in der Regel problemlos möglich ist. Das durch die Wirbelströme im Abschirmkörper erzeugt Feld, das eine definierte Amplitude und Zeitkonstante hat, läßt sich dann durch eine entsprechende Gestaltung des zeitlichen Verlaufes der Ströme in den jeweiligen Gradientenspulen einwandfrei elektronisch kompensieren, wie es aus der EP 01 64 199 A1 bekannt ist.

Die Erfindung bietet aber auch die Möglichkeit, eine praktisch vollkommene Abschirmung zu erzielen, die eine elektronische Kompensation unnötig macht, indem in weiterer Ausgestaltung der Erfindung der Abschirmkörper aus supraleitendem Material hergestellt und innerhalb des Heliumtankes angeordnet wird, so daß die Zeitkonstante des Feldes, das auf die in dem Abschirmkörper induzierten Wirbelströme zurückgeht, unendlich groß ist, und dieses Feld lediglich zusammen mit den Gradientenfeldern ein- und ausgeschaltet wird und während der Dauer der Gradientenfelder konstant ist, so daß es den Verlauf der Gradientenfelder nicht beeinflußt. Allerdings muß bei der Verwendung eines Abschirmkörpers aus supraleitendem Material innerhalb des Heliumtankes dafür Sorge getragen werden, daß der Abschirmkörper während des Ladens der Magnetspule auf einer über der kritischen Temperatur liegenden Temperatur gehalten wird, damit der beim Laden der Magnetspule induzierte Strom nach Abschluß des Ladevorganges wieder abklingen kann. Erst dann darf der Abschirmkörper auf eine unterhalb der kritischen Temperatur liegende Temperatur abgekühlt werden.

Ein supraleitender Abschirmkörper kann beispielsweise aus einem Gewebe aus supraleitenden Fasern bestehen. Auch wäre es möglich, den Abschirmkörper aus einem dünnen Blech herzustellen, das aus einer supraleitenden Legierung besteht und eine Gitterstruktur aufweist. Aus Gründen der elektrischen Stabilität des supraleitenden Zustandes sollte der Durchmesser der Fasern bzw. der Stäbe der Gitterstruktur nicht größer sein als etwa 0,5 mm. Dabei versteht es sich, daß bei der Verwendung eines Gewebes die supraleitenden Fasern an ihren Kreuzungspunkten supraleitend miteinander verbunden, z.B. verschweißt sein müssen. Bei der Verwendung eines Bleches könnte die siebartige Struktur beispielsweise mittels eines Beiz- oder Ätzverfahrens hergestellt werden. Als supraleitendes Material kommt insbesondere eine Niob-Titan-Legierung in Frage.

Wie bereits erwähnt, kann der Abschirmkörper als ein selbsttragendes Rohr ausgebildet sein. Dabei kann auch ein aus einem hochreinen Metall bestehendes Rohr innerhalb des Heliumtankes angeordnet sein. In diesem Fall ist es besonders vorteilhaft, wenn das den Abschirmkörper bildende Rohr bei der Betriebstemperatur an der Innenseite des Tragrohres der Magnetspule fest anliegt. Das Tragrohr ist dann in der Lage, im Falle eines Verlustes der Supraleitung (Quench) durch Lorentzkräfte verursachte, in Umfangsrichtung des Abschirmkörpers wirkende Zugspannungen aufzunehmen und solchen Abschirmkörper vor mechanischer Überbeanspruchung zu bewahren.

Anstatt als selbsttragendes Rohr ausgebildet zu sein kann der Abschirmkörper auch als Schicht aus einem Material extrem hoher Leitfähigkeit auf ein tragendes Rohr der Magnetanordnung aufgebracht sein, insbesondere auf die Außenseite der inneren Wand des Heliumtankes oder auch auf die Innenseite des Tragrohres für die Magnetspule. So besteht beispielsweise die Möglichkeit, solche Schichten aus Reinaluminium oder auch hochreinem Kupfer durch Flammspritzen oder galvanisch aufzubringen.

Die Erfindung wird im folgenden anhand des in der Zeichnung dargestellten Ausführungsbeispieles und von Diagrammen näher beschrieben und erläutert. Es zeigen:

Fig. 1 einen schematischen Längsschnitt durch eine supraleitende Magnetanordnung nach der Erfindung in Verbindung mit einem System von Gradientenspulen,

Fig. 2 das der theoretischen Beschreibung der Erfindung zugrunde liegende Ersatzschaltbild einer Gradientenspule, die von zwei metallischen Rohren umgeben ist, und

Fig. 3 bis 5 Diagramme der Amplituden und Zeitkonstanten der Wirbelströme, die in der durch das Ersatzschaltbild nach Fig. 2 wiedergegebenen Anordnung auftreten.

Bei supraleitenden Magnetsystemen, die zur Durchführung der Tomographie und der volumenselektiven Spektroskopie auf der Basis der kernmagnetischen Resonanz eingesetzt werden, erzeugt eine supraleitende Magnetspule, die mit flüssigem Helium auf einer Temperatur von 4,2 K gehalten wird, ein räumlich homogenes und zeitlich konstantes Magnetfeld $H_0$. Die erzeugten Mangetfeldstärken liegen etwa im Bereich von 0,5 bis 7 Tesla. Zusätzlich werden zeitlich steuerbare, räumlich konstante Feldgradienten benötigt, die von Zusatzspulen in drei zueinander orthogonalen Richtungen des Raumes erzeugt und dem homogenen Feld $H_0$ überlagert werden. Die maximale Stärke der benötigten Feldgradienten ist von der Größenordnung $10^{-2}$ T/m. Die Gradientenspulen genannten Zusatzspulen sind in der Regel auf einem zylindrischen Tragerohr befestigt, das das zu untersuchende Objekt relativ eng umschließt. Für die Durchführung von Tomographie-Verfahren ist es wichtig, daß die Feldgradienten zeitlich stufenförmig, d.h. mit einer Ein- bzw. Abschaltzeit in der Größenordnung von 1 ms ein- und abgeschaltet werden können.

Der Erfüllung dieser Forderung steht entgegen, daß das System der Gradientenspulen von einer Vielzahl meist zylindersymmetrischen Metallstrukturen umgeben ist, die Bestandteile des die Magnetspule umschließenden Kryostaten sind. In diesen meist rohrförmigen Gebilden werden beim Ein- und Ausschalten der Feldgradienten durch induktive Kopplung mit den Gradientenspulen Wirbelströme induziert, die ihrerseits zeitver-änderliche Störfelder erzeugen, welche sich dem Feld der Gradientenspulen überlagern. Diese Störfelder füh-ren zu einer Beeinträchtigung der Qualität und des Informationsgehaltes von Untersuchungen auf der Basis der Kernspin-Tomographie und Spektroskopie. Die Störfelder lassen sich jedoch beherrschen oder sogar eliminieren, wenn ein nach der Erfindung ausgebildeter Abschirmkörper in die Magnetanordnung integriert wird.

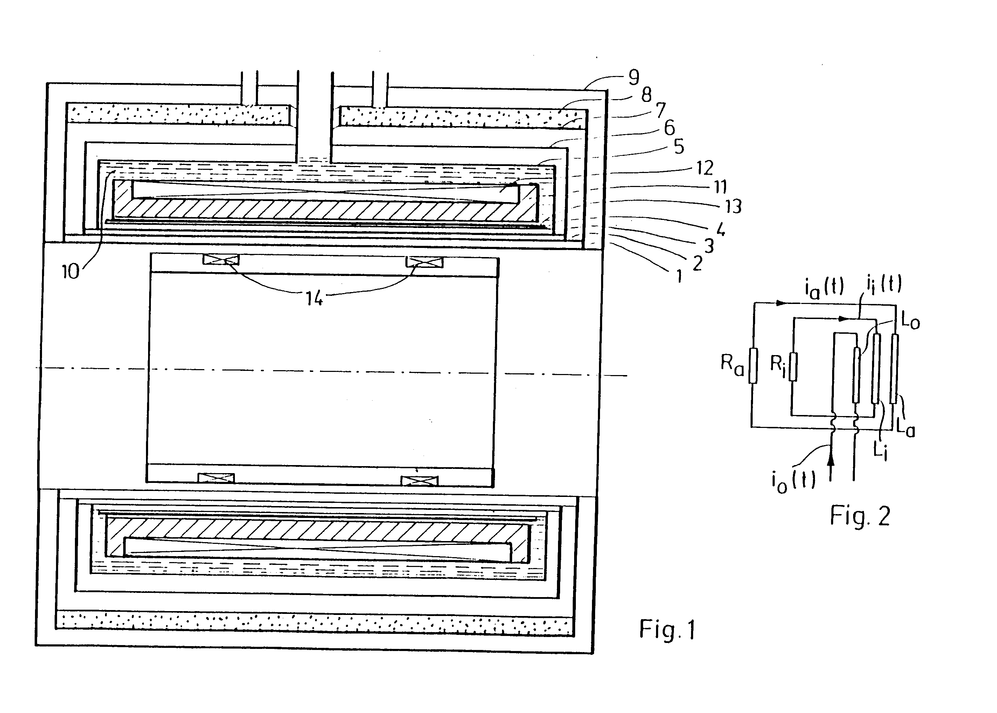

Fig. 1 zeigt eine nach der Erfindung ausgebildete Magnetanordnung. Sie ist aus einer Vielzahl konzentrisch zueinander angeordneter Rohre 1 bis 9 aufgebaut, die von innen nach außen den Innenmantel 1 des Kryostaten, einen stickstoff-gekühlten Strahlungsschild 2, einen gasgekühlten Strahlungsschild 3, die Innenwand 4 eines Heliumtankes, die Außenwand 5 des Heliumtankes, einen äußeren, gasgekühlten Strahlungsschild 6, die Innenwand 7 eines Stickstofftankes, die Außenwand 8 des Stickstofftankes und den Außenmantel 9 des Kryostaten bilden. Innerhalb des von den Wänden 3, 4 begrenzten Heliumtankes 10 befindet sich ein Trägerrohr 11 mit der aus supraleitendem Draht bestehenden Magnetspule 12. Weiterhin ist im Inneren des Heliumtankes 10 und innerhalb des Trägerrohres 11 für die Magnetspule 12 ein rohrförmiger Abschirmkörper 13 angeordnet. Dieser Abschirmkörper 13 besteht aus Reinaluminium und hat bei der Temperatur von flüssigem Helium eine elektrische Leitfähigkeit von mehr als $3 \times 10^9$ Siemens/m. Bei einer Wandstärke des Abschirmkörpers von 10 mm ergibt sich aus dem Produkt von Wandstärke und elektrischer Leitfähigkeit eine Leit-zahl von $p \geqq 3 \times 10^7$ Siemens. Diese Leitzahl übersteigt die Leitzahl der anderen Rohre mindestens um den Faktor 10. Auf diese Weise wird erreicht, daß das Gesamtsystem sich so verhält, als ob beim Schalten der Gradientenfelder nur in dem Abschirmkörper Wirbelströme induziert werden, die eine definierte Größe und Zeitkonstante haben, so daß das dadurch erzeugte Störfeld durch entsprechende Gestaltung des zeitlichen Verlaufs und der Größe der Ströme in den Gradientenspulen 14, die im Inneren des Innenmantels 1 angeordnet sind, auf bekannte Weise praktisch vollkommen kompensiert werden kann.

Die Wirkungsweise des nach der Erfindung angeordneten und abgebildeten Abschirmkörpers wird verständlich, wenn man das Verhalten einer Anordnung betrachtet, die aus einer Gradientenspule und zwei die Gradientenspule umgebenden, elektrisch leitfähigen Rohren betrachtet. Das Ersatzschaltbild einer solchen Anordnung gibt Fig. 2 wieder. In diesem Ersatzschaltbild ist die Gradientenspule als Induktivität $L_0$ dargestellt. Die die Gradientenspule umgebenden Metallrohre werden als resistiv gedämpfte und induktiv sowohl miteinander als auch mit der Gradientenspule gekoppelte Kreise aufgefaßt. Demgemäß wird das innere Metallrohr durch den aus der Induktivität $L_i$ und den Widerstand $R_i$ bestehenden Kreis wiedergegeben, während das äußere Metallrohr entsprechend den aus der Induktivität $L_a$ und dem Widerstand $R_a$ bestehenden Kreis bildet. Die induktive Kopplung der Gradientenspule mit den Metallrohren wird durch Gegeninduktivitäten $M_{0i}$ und $M0_a$ beschrieben. Die induktive Kopplung der Metallrohre untereinander wird durch die Gegeninduktivität $M_{ia}$ be-schrieben. Die Stärke des der Gradientenspule zugeführten Stromes ist $i_0$ (t) und diejenige der Wirbelströme im inneren Metallrohr $i_i$ (t) sowie diejenige der Wirbelströme im äußeren Metallrohr $i_a$ (t). Ein solches System wird durch die Transformatorgleichung beschrieben, deren Lösung [1] für den speziellen Fall besonders einfach ist, da es sich bei der Gradientenspule und bei den sie umgebenden Metallrohren um unendlich lange Zylinder handelt. Für die Geometrie von realen Gradientenspulen und metallischen Rohren endlicher Länge sind demgegenüber nur geringfügige quantitative Abweichungen zu erwarten. Bei der Analyse erweist es sich ferner als hilfreich, wenn jedem einzelnen Metallrohr eine eigene Zeitkonstante $\tau$ zugeordnet wird, die sich ergeben würde, wenn das Metallrohr die einzige mit der Gradientenspule gekoppelte Struktur wäre. Für das unendlich lange Rohr ergibt sich die dem Rohr eigene "Einzelzeitkonstante" als Quotient aus Induktivitätsbelag und Wi-derstandsbelag zu

$$\tau = 1/2 \, (\mu_0.r.\sigma.\Delta r) = 1/2 \, (\mu_0.r.p)$$

Hierin sind

| | |
|---|---|
| $\mu_0$ | Induktionskonstante |
| r | Radius des Metallrohres |
| $\Delta r$ | Wandstärke des Metallrohres |
| $\sigma$ | Leitfähigkeit des Metallrohres |
| $p = \sigma . \Delta r$ | Leitzahl des Metallrohres |

Die Einzelzeitkonstante des Spulenkörpers beträgt bei Ganzkörpertomographen etwa 0,4 s. Von gleicher Größenordnung sind auch die Einzelzeitkonstanten der beiden inneren Strahlungsschilde. Weiterhin wurde für die Gradientenspule ein Radius von 40 cm, für das innere Metallrohr ein Radius von 55 cm und für das äußere Metallrohr ein Radius von 62,5 cm angenommen. Damit entspricht das innere Metallrohr geometrisch et-

[1] siehe Anhang

wa dem Strahlungsschildern und das äußere Metallrohr etwa dem Trägerrohr der Magnetspule eines Ganzkörpertomographen.

Die Ergebnisse der Lösung der Transformatorgleichung und der theoretischen Analyse lassen sich wie folgt zusammenfassen:

Bei Vorhandensein von n Metallzylindern fließen in jeden Metallzylinder Ströme, die sich als Überlagerung von n Exponentialfunktionen mit n Zeitkonstanten darstellen lassen.

Die Zeitkonstanten der verschiedenen Stromkomponenten sind in allen Metallzylindern gleich, die Amplituden jedoch unterschiedlich.

Die Zeitkonstanten des induktiv gekoppelten Systems sind nicht mit den Einzelzeitkonstanten identisch.

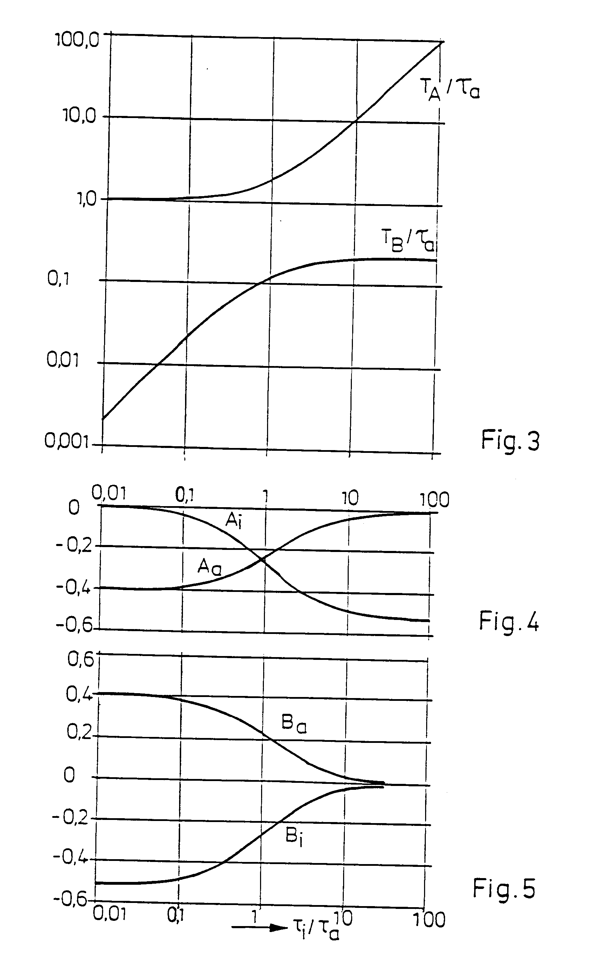

Für den Fall zweier Metallrohre ergeben sich zwei Systemzeitkonstanten $T_A$ und $T_B$. Die Größe der Systemzeitkonstanten $T_A$ und $T_B$, jeweils bezogen auf die Einzelzeitkonstante des Außenrohres $\tau_a$, ist in Abhängigkeit vom Verhältnis der Einzelzeitkonstanten $\tau_i/\tau_a$ des inneren bzw. des äußeren Metallrohres in Fig. 3 dargestellt. Die längere der beiden Systemzeitkonstanten $T_A$ ist dabei ungefähr gleich der Summe der Einzelzeitkonstanten $\tau_a + \tau_i$. Die lange Systemzeitkonstante $T_A$ ist sowohl im Fall $\tau_i \ll \tau_a$ als auch im Fall $\tau_i \gg \tau_a$ ungefähr gleich der jeweils größeren Einzelzeitkonstanten $\tau_i$ bzw. $\tau_a$. Die kleinere Systemzeitkonstante $T_B$ ist stets erheblich kleiner als die jeweils kleinere Einzelzeitkonstante.

Sowohl im inneren als auch im äußeren Metallrohr fließen Ströme, die mit der Systemzeitkonstanten $T_A$ bzw. $T_B$ abklingen. Fig. 4 zeigt die Abhängigkeit der zur größeren Systemzeitkonstanten $T_A$ gehörende Stromamplituden $A_i$ im inneren Metallrohr bzw. $A_a$ im äußeren Metallrohr wieder in Abhängigkeit vom Verhältnis der Einzelzeitkonstanten. Im Fall eines Innenrohres mit besonders großer Einzelzeitkonstanten ($\tau_i \gg \tau_a$) verschwindet die Stromamplitude $A_a$ im Außenrohr, während der Betrag der Stromamplitude $A_i$ im Innenrohr besonders groß ist. Im Fall eines Innenrohres mit geringer Leitfähigkeit und demgemäß kleiner Einzelzeitkonstanten ($\tau_i \ll \tau_a$) trägt allein das äußere Rohr mit der langen Systemzeitkonstanten Strom. Die Stromamplituden $A_i$ und $A_a$ sind grundsätzlich negativ, d.h. die Wirbelströme fließen entgegengesetzt zur Richtung des Erregerstromes. Die in dem äußeren und dem inneren Metallrohr fließenden Ströme mit der Systemzeitkonstanten $T_B$ sind wieder in Abhängigkeit vom Verhältnis der Einzelzeitkonstanten $\tau_i/\tau_a$ in Fig. 5 dargestellt. Im Falle eines hochleitfähigen Innenrohres ($\tau_i \gg \tau_a$) verschwinden die zur kleineren Systemzeitkonstanten $T_B$ gehörigen Stromamplituden $B_i$ und $B_a$ beide völlig. Im umgekehrten Fall sind die Stromamplituden groß und zueinander stets entgegengesetzt gerichtet.

Für die Erfindung ist von Bedeutung, daß der Abschirmkörper einen metallischen Zylinder mit sehr hoher Leitfähigkeit und demgemäß sehr großer Einzelzeitkonstante $\tau$ ist. Für die außerhalb des Abschirmkörpers liegenden Rohre bildet der Abschirmkörper das innere Rohr, so daß hierfür $\tau_i \gg \tau_a$ gilt. Hierfür gehen sämtliche Stromamplituden $A_a$ und $B_a$ im äußeren Rohr gegen 0 (siehe Fig. 4 und 5). Es bleibt lediglich die Stromamplitude $A_i$ mit der langen Systemzeitkonstante $T_A$ im inneren Zylinder erhalten. Die Systemzeitkonstante $T_A$ ist darüberhinaus mit der Einzelzeitkonstante $\tau_i$ des inneren Zylinders identisch (siehe Fig. 3). Demgemäß verhält sich das gesamte System in einer Weise, als ob nur das innere Metallrohr, also der Abschirmkörper vorhanden wäre. Die äußere Struktur wird demgemäß durch den Abschirmkörper praktisch vollständig abgeschirmt.

An sich wäre es aus diesem Grunde sinnvoll, den abschirmkörper so dicht wie möglich an die Gradienspule heranzubringen, also den innersten Strahlungsschild oder sogar den Innenmantel des Kryostaten als Abschirmkörper auszubilden. Es ist jedoch nicht möglich, die für die große Einzelzeitkonstante $\tau_i$ erforderliche hohe Leitzahl mit einem ausreichend dünnwandigen Material zu erzielen, ohne den Abschirmkörper auf eine Temperatur von 10 K und weniger abzukühlen. Wie bereits oben erwähnt, ist eine Vergrößerung der Einzelzeitkonstanten des Abschirmkörpers durch eine hinreichend große Wandstärke, die dann mehrere Zentimeter betragen müßte, nicht sinnvoll, da derartig dickwandige Metallzylinder als Vielzahl dünnwandiger, ineinander geschachtelter Rohre aufgefaßt werden müssen, zu denen wiederum eine Vielzahl von Systemzeitkonstanten gehört, die nicht mehr beherrschbar ist. Daher ist es unerläßlich, den Abschirmkörper auf Temperaturen im Bereich der Temperatur des flüssigen Heliums abzukühlen, weil nur bei dieser Temperatur reine Metalle eine hinreichend große elektrische Leitfähigkeit aufweisen.

Es bleibt daher das Problem bestehen, daß sich innerhalb des Abschirmkörpers mit der großen Einzelzeitkonstanten Strahlungsschilde als leitfähige Rohre mit deutlich kleineren Einzelzeitkonstanten befinden. Diese Situation wird durch das Modell zweier gekoppelter metallischer Rohre beschrieben, für welche $\tau_i \ll \tau_a$ ist. Wie Fig. 4 und 5 zeigen, sind für diesen Fall die zu den beiden Systemzeitkonstanten $T_A$ und $T_B$ gehörigen Stromamplituden $A_a$, $B_a$ und $B_i$ in den beiden Strahlungsschildern groß. Die lange Systemzeitkonstante $T_A$ ist hier mit der Einzelzeitkonstante $\tau_a$ des Abschirmkörpers identisch, so daß sich lediglich die Stärke des in dem Abschirmkörper aufgrund der äußeren Abschirmung fließenden Stromes ändert und daher bei der elektronischen Kompensation des mit der Einzelzeitkonstante des Abschirmkörpers abklingenden Feldes berücksichtigt werden kann.

Die Größe der kleinen Systemzeitkonstanten $T_B$ läßt sich dagegen durch die Wahl einer hinreichend klei-

nen Einzelzeitkonstanten $\tau_i$ der inneren Rohre so stark reduzieren, daß ein Kernspin-Experiment nicht mehr gestört wird, weil die "Lebensdauer" der entsprechenden Störfelder erheblich kleiner ist als die "Totzeit" innerhalb derer die Stromstärke in den Gradientenspulen von 0 auf die volle Stärke geregelt wird und umgekehrt. Diese Zeit beträgt etwa 1 ms.

Diese Verhältnisse lassen sich realisieren, wenn man die bei dem dargestellten Ausführungsbeispiel vorhandenen Strahlungsschilde aus unmagnetischem Stahl mit einer Wandstärke von je 3 mm herstellt. Die Erfahrung zeigt, daß die thermische Leitfähigkeit solcher Strahlungsschilde noch groß genug ist, um den Verbrauch des Kryostaten an kryogenen Flüssigkeiten klein zu halten.

Demgemäß hat die in Fig. 1 dargestellte Magnetanordnung den folgenden Aufbau:

Der die Raumtemperaturbohrung des Kryostaten begrenzende Innenmantel 1 wird von einem Rohr aus glasfaserverstärktem Kunststoff mit einem Innendurchmesser von 600 mm und einer Länge von 1670 mm gebildet. Die Wandstärke des Innenmantels beträgt 7 mm. Dieses Rohr wird von dem stickstoff-gekühlten Strahlungsschild umgeben, das von einem Rohr aus unmagnetischem Stahl mit einer Wandstärke von 3 mm gebildet wird. Der Innendurchmesser dieses Rohres beträgt 640 mm und seine Länge 1550 mm. Dieser Strahlungsschild wird von einem weiteren Rohr aus unmagnetischem Stahl umgeben, das den gasgekühlten Strahlungsschild 3 bildet. Die Wandstärke beträgt wieder 3 mm, der Innendurchmesser 674 mm und die Länge 1510 mm. Diesen Strahlungsschild umgibt der Heliumtank 10, dessen Innenwand ebenfalls von einem Rohr aus unmagnetischem Stahl mit einer Wandstärke von 4 mm, einem Innendurchmesser von 708 mm und einer Länge von 1400 mm gebildet wird. Innerhalb des Heliumtankes befindet sich dann der aus einem Aluminiumrohr mit einer Wandstärke von 10 mm bestehende Abschirmkörper, der von dem Trägerrohr 11 für die Magnetspule 12 dicht umgeben wird. Bei Raumtemperatur beträgt der Innendurchmesser des Trägerrohres 720 mm und ist damit nur geringfügig größer als der äußere Durchmesser des Abschirmkörpers, der bei Raumtemperatur 717 mm beträgt. Beim Einkühlen des Heliumtankes mit flüssigem Helium reduziert sich der Zwischenraum zwischen dem Trägerrohr 11 und dem Abschirmkörper 13 wegen der unterschiedlichen thermischen Kontraktionen des Trägerrohres und des Abschirmkörpers, so daß das Trägerrohr den Abschirmkörper bei der Temperatur des flüssigen Heliums praktisch wie eine Bandage umschließt. Diese Funktion des Spulenkörpers als Bandage für den Abschirmkörper kann von Bedeutung sein, wenn das von der supraleitenden Magnetspule 12 erzeugt Magnetfeld im Falle eines "Quenches", also bei einem schnellen Übergang vom supraleitenden in den normal leitenden Zustand, innerhalb weniger Sekunden von der ursprünglichen Stärke auf verschwindend kleine Werte abklingt. Dabei werden im Abschirmkörper sehr starke Wirbelströme induziert, die im Abschirmkörper Lorentz-Kräfte erheblicher Stärke erzeugen. Diese Kräfte verursachen im Abschirmkörper erhebliche Zugspannungen in Umfangsrichtung. Die stützende Wirkung des eng anliegenden Trägerrohres 11 des Spulenkörpers 12 bewahrt dann den Abschirmkörper 13 vor einer mechanischen Überbeanspruchung.

Es versteht sich, daß die Erfindung nicht auf das dargestellte Ausführungsbeispiel beschränkt ist, sondern Abweichungen davon möglich sind, ohne den Rahmen der Erfindung zu verlassen. Da die Temperatur des Abschirmkörpers nicht unbedingt gleich der Temperatur des flüssigen Heliums sein muß, sondern bis zu etwa 10 K betragen kann, ohne daß die Wirkung des Abschirmkörpers erheblich beeinträchtigt wird, könnte der Abschirmkörper auch außerhalb des Heliumtankes angeordnet sein, auch wenn er sich in dessen unmittelbarer Nähe befinden muß. Weiterhin ist es nicht erforderlich, den Abschirmkörper als freitragendes Rohr auszubilden, sondern er könnte auch von einer Beschichtung der Innenwand des Heliumtankes oder auch der Innenseite des Trägerrohres für die Magnetspule gebildet werden. Geeignete Schichten aus reinen Metallen lassen sich beispielsweise durch Flammspritzen oder auch galvanisch aufbringen. Von besonderer Bedeutung ist auch die Möglichkeit, den Abschirmkörper aus einem supraleitenden Material herzustellen. In diesem Fall würde die Einzelzeitkonstante des Abschirmkörpers und damit auch die durch den Abschirmkörper bedingte Systemzeitkonstante unendlich groß, mit dem Ergebnis, daß das durch die Wirbelströme erzeugte Störfeld zeitlich konstant wäre und daher nicht berücksichtigt zu werden braucht. Dabei könnte der supraleitende Abschirmkörper aus einem Gewebe oder Geflecht supraleitender Fasern, die an ihren Kreuzungspunkten supraleitend miteinander verbunden sind, oder auch durch ein Blech mit einer gitter- oder siebartigen Struktur bestehen. Solche Strukturen lassen sich auf vielfältige Weise durch mechanische Bearbeitung oder auch durch Ätzen herstellen. Supraleitenden Schichten brauchen natürlich keine große Wandstärke zu haben und können auf Trägern unterschiedlichster Struktur aufgebracht sein. Insgesamt läßt das vorstehend dargelegte Prinzip der Erfindung dem Fachmann viele Möglichkeiten zu seiner Realisierung bei Magnetanordnungen mit unterschiedlichem Aufbau.

Eine dieser Möglichkeiten, die als eine leicht realisierbare Alternative zu einem aus einem Geflecht supraleitender Fasern oder aus einem supraleitenden Blech bestehenden Abschirmkörper anzusehen ist, besteht darin, den Abschirmkörper als ein System von Abschirmspulen aus supraleitendem Draht auszubilden, wobei dieses System drei je einer der Gradientenspulen zugeordnete Abschirmspulen umfaßt, deren grundsätzliche Geometrie derjenigen der jeweiligen Gradientenspule(n) ähnlich ist. Der Windungsverlauf der supraleitenden Abschirmspulen wird "stromlinienförmig" so verlegt, wie es der Stromverteilung in einem unendlich gut leitfähigen Abschirmzylinder entspricht.

Jede der Abschirmspulen bildet hierbei einen geschlossenen, supraleitenden Stromkreis, der mittels eines supraleitenden Schalters absperrbar bzw. schließbar ist. Diese supraleitenden Schalter werden beim Laden der Hauptspule geöffnet, das heißt die supraleitenden Abschirm-Stromkreise gesperrt, um ein induktives Aufladen der Abschirmspulen zu verhindern. Im geschlossenen Zustand der supraleitenden Schalter und damit auch der Abschirmstromkreise schirmen die Abschirmspulen das von den Gradientenspulen erzeugte Feld nach außen ab, wobei sich die in den Abschirmspulen fließenden Ströme induktiv "automatisch" auf den eine optimale Abschirmung vermittelnden Betrag einstellen.

Die radial innerhalb der Hauptspule angeordneten supraleitenden - Abschirmspulen sind zweckmäßigerweise im Heliumtank des Kryostaten angeordnet.

Die Abschirmspulen können - durch Ladung mit Gleichstrom - auch zur Erzeugung von Zusatzfeldern ausgenutzt werden, mittels derer Inhomogenitäten des Hauptspulenfeldes kompensierbar sind.

Zu einer mathematischen Beschreibung des Einschaltverhaltens des durch das Ersatzbild der Fig. 2 repräsentierten, die Gradientenspule mit der Induktivität Lo und die diese umgebenden Metallrohre mit den Induktivitäten $L_i$ und Lo sowie den Widerständen $R_i$ und Ra behafteten Metallrohre umfassenden induktiv gekoppelten Systems sei, wie vorstehend schon erwähnt, von der vereinfachenden Annahme ausgegangen, daß es sich bei der Gradientenspule und den diese umgebenden Metallrohren um unendlich lange "Zylinder" handle.

In dieser Näherung, die, verglichen mit einer exakten, die realen endlichen Längen der genannten Elemente berücksichtigenden, jedoch wesentlich aufwendigeren Rechnung nur geringfügig abweichende Ergebnisse liefert, gelten für die beiden Metallrohre, welche die Gradientenspule, koaxial umgeben, die folgenden Transformatorgleichungen:

$$u_i(t) = M_{oi}\,\overset{\circ}{I}_o + L_i\,\overset{\circ}{I}_i + M_{ia}\,\overset{\circ}{I}_a = -R_i\,i_i \quad\left.\begin{array}{c}\\[3ex]\\[3ex]\end{array}\right\}$$

sowie

$$u_a(t) = M_{oa}\,\overset{\circ}{I}_o + M_{ai}\,\overset{\circ}{I}_i + L_a\,\overset{\circ}{I}_a = -R_a\,i_a$$

(I)

mit:

$$\overset{\circ}{i} = \frac{d_i}{d_t};$$

$$M_{ia} = M_{ai} = M,$$

sowie

$$i_o(t) = I_o\,u(t) = \left\{\begin{array}{ll} I_o & \text{für } t > 0 \\ 0 & \text{für } t < 0, \end{array}\right.$$

wobei t den Zeitpunkt des Einschaltens des die Gradientenspule. durchfließenden Stromes bezeichnet.

Da für t > o wegen $I_0$ = const. gilt:

$$\overset{\circ}{i}_0 = \frac{d_{i0}}{dt} = 0,$$

folgt aus den beiden Transformatorgleichungen für t > o,

$$L_i\overset{\circ}{i}_i + M_{ia}\overset{\circ}{i}_a = -R_i i_i \quad (a)$$
$$M\overset{\circ}{i}_i + L_a\overset{\circ}{i}_a = -R_a i_a \quad (b)$$

Aus der Bezeichnung (a) folgt unmittelbar

$$\overset{\circ}{i}_a = -\frac{L_i\overset{\circ}{i}_i}{M} - \frac{R_i i_i}{M},$$

sowie durch Differentiation

$$\overset{\circ\circ}{i_a} \quad = \quad - \quad \frac{L_i \overset{\circ\circ}{i_i}}{M} \quad - \quad \frac{R_i \overset{\circ}{i_i}}{M}$$

Diese Beziehungen für $\overset{\circ}{i_a}$ und $\overset{\circ\circ}{i_a}$ in die differenzierte Transformatorgleichung (b) eingesetzt ergibt für $i_i$, die folgende Differentialgleichung:

$$(1 - k)\overset{\circ\circ}{i_i} + (\frac{1}{\tau_i} + \frac{1}{\tau_a})\overset{\circ}{i_i} + \frac{1}{\tau_i\tau_a} i_i = 0 \quad (c)$$

mit

$$k = \frac{M^2}{L_i L_a} ; \tau_i = \frac{L_i}{R_i}$$

und

$$\tau_a = \frac{L_a}{R_a} ;$$

dieselbe Differentialgleichung ergibt sich auch für $i_a$ :
Die allgemeine Lösung der Gleichung (c), als homogener linearer Differentialgleichung 2. Ordnung mit konstanten Koeffizienten lautet:

$$i_i(t) = A_i I_0 e^{\alpha t} + B_i I_0 e^{\beta t} \quad (d)$$

analog gilt für den Strom $i_a(t)$ in dem äußeren Metallrohr

$$i_a(t) = A_a I_0 e^{\alpha t} + B_a I_0 e^{\beta t} \quad (e)$$

wobei mit $\alpha$ und $\beta$ konstant bezeichnet sind, welche durch die Beziehungen

$$\alpha = - \frac{\tau_i + \tau_a}{2(1-k)\,\tau_i\tau_a} + \sqrt{\frac{(\tau_i + \tau_a)^2}{4(1-k)^2\tau_i^2\tau_a^2} - \frac{1}{(1-k)\,\tau_i\tau_a}} \quad (f)$$

bzw.

$$\beta = - \frac{\tau_i + \tau_a}{2(1-k)\,\tau_i\tau_a} + \sqrt{\frac{(\tau_i + \tau_a)^2}{4(1-k)^2\,\tau_i^2\tau_a^2} - \frac{1}{(1-k)\,\tau_i\tau_a}} \quad (g)$$

gegeben sind.

(d) und (e), die allgemeine Lösung in die Transformatorgleichung (a) eingesetzt und Vergleich der Koeffizienten für gleiche Exponentialfaktoren ergibt sodann
für die Amplitudenverhältnisse

$$f\alpha = \frac{A_i}{A_a}$$

und

$$f\beta = \frac{B_i}{B_a}$$

die Beziehungen:

$$f\alpha = \frac{A_i}{A_a} = - \frac{M\alpha}{\alpha L_i + R_i} \quad (h)$$

sowie

$$f\beta = \frac{B_i}{B_a} = - \frac{M\beta}{\beta L_i + R_i} \quad (i)$$

Da für $t < o$ gilt:

$$i_i(t) = i_a(t) \equiv 0,$$

so gilt auch

$$i_i(t) = (A_i e^{\alpha t} + B_i e^{\beta t})\, I_0\, u(t),$$

sowie

$$i_a(t) = (A_a e^{\alpha t} + B_a e^{\beta t})\, I_0\, u(t)$$

und

$$i_0(t) = I_0\, u(t)$$

Für die zeitlichen Ableitungen der vorstehend angegebenen Größen $i_i(t)$, $i_a(t)$ und $i_0(t)$ gilt:

$$\overset{\circ}{i_i}(t) = (A_i + B_i)\, I_0\, \delta(t) + (\alpha A_i e^{\alpha t} + \beta B_i e^{\beta t})\, I_0\, u(t)$$
$$\overset{\circ}{i_a}(t) = (A_a + B_a)\, I_0\, \delta(t) + (\alpha A_a e^{\alpha t} + \beta B_a e^{\beta t})\, I_0\, u(t)$$
$$\overset{\circ}{i_0}(t) = I_0\, \delta(t)$$

wobei mit $\delta(t)$ die Dirac'sche $\delta$-Funktion bezeichnet ist.

Setzt man diese für die Ströme und deren zeitliche Ableitungen angegebenen Beziehungen in die Transformatorgleichungen (I) ein und erfüllt diese Gleichungen isoliert für alle diejenigen Terme, deren Zeitverhalten

durch $\delta(t)$ bestimmt ist, so ergeben sich folgende Ausdrücke:

$$f_i = A_i + B_i = \left( \frac{L_a \ Mo_i}{M^2} - \frac{Mo_a}{M} \right) \ \frac{k}{k-1} \qquad (j)$$

und

$$f_a = A_a + B_a = \left( \frac{M \ Mo_i}{L_i \ L_a} - \frac{Mo_a}{L_a} \right) \ \frac{1}{1-k} \qquad (k)$$

Aus den Beziehungen (h), (i), (j) und (k) ergibt sich für die Amplituden Ai, Bi, Aa und Ba unmittelbar:

$$Ba = \frac{f_i - f_\alpha f_a}{f_\beta - f_\alpha}$$
$$Aa = f_a - B_a$$
$$Ai = f_\alpha A_a$$
$$Bi = f_\beta B_a$$

Desweiteren ergeben sich für die lange Systemkonstante $T_A$ und die kleine Systemkonstante $T_B$ die Beziehungen :

$$T_A = -\frac{1}{\alpha}$$

sowie

$$T_B = -\frac{1}{\beta}.$$

**Patentansprüche**

**Patentansprüche für folgende Vertragsstaaten : FR, NL**

1.   Supraleitende Magnetanordnung, insbesondere für Kernspin-Tomographiegeräte, mit einer aus supraleitendem Draht und einem Trägerrohr (11) bestehenden, im wesentlichen zylindrischen Magnetspule (12), mit einem zur Magnetspule (12) koaxialen Kryostat, der aus einer Anzahl von zur Magnetspule (12) koaxialen, innerhalb und außerhalb der Magnetspule (12) angeordneten metallischen Rohren (1 bis 9) besteht, von denen wenigstens einige paarweise durch Endwände miteinander verbunden sind, wobei das äußerste (9) und das innerste Rohr (1) Bestandteile eines äußeren Mantels sind, und wobei die der Magnetspule (12) benachbarten Rohre (4, 5) die Wandungen eines die Magnetspule (12) umschließenden Heliumtankes (10) bilden und die übrigen Rohre (2, 3, 6-8) zwischen den Wandungen des Heliumtankes (10) und den Rohren des Mantels angeordnete Strahlungsschilde sind und gegebenenfalls die Wandungen (7, 8) eines die Magnetspule (12) umgebenden Stickstofftankes bilden, mit innerhalb des innersten Rohres angeordneten Gradientspulen (14), mittels derer für die Tomographie geeignete, zeitlich veränderbare Feldgradienten erzeugbar sind, und mit einem zwischen dem innersten Rohr (1) und der Magnetspule (12) angeordneten zylindrischen, der Abschirmung der Gradientenfelder nach außen dienenden Abschirmkörper (13), dessen dem Produkt aus seiner elektrischen Leitfähigkeit und seiner Wandstärke gleiche elektrische Leitzahl erheblich größer ist als die Leitzahl der weiter außen liegenden Rohre, dadurch gekennzeichnet, daß der Abschirmkörper (13) in engem thermischen Kontakt mit dem Heliumtank (10) angeordnet ist, daß dieser Körper aus einem elektrisch sehr gut leitenden Material mit einer Wandstärke von höchstens 10 mm besteht, und
daß alle anderen Rohre (1 bis 9, 11) der Magnetanordnung innerhalb und außerhalb des Abschirmkörpers (13) aus einem im Vergleich mit der elektrischen Leitfähigkeit des Abschirmkörpers (13) elektrisch schlecht leitendem Material bestehen, derart, daß bei Betriebstemperatur der Magnetanordnung die Leitzahl des Abschirmkörpers (13) wenigstens das Zehnfache der Leitzahlen sowohl der außerhalb als auch der innerhalb des Abschirmkörpers liegenden Rohre (1 bis 9, 11) beträgt.

2.   Magnetanordnung nach Anspruch 1, dadurch gekennzeichnet, daß die elektrische Leitfähigkeit des Abschirmkörpers (13) bei der Betriebstemperatur größer ist als $10^9$ Siemens/m.

3. Magnetanordnung nach Anspruch 1 oder 2, dadurch gekennzeichnet, daß der Abschirmkörper (13) aus hochreinem Aluminium besteht.

4. Magnetanordnung nach Anspruch 1 oder 2, dadurch gekennzeichnet, daß der Abschirmkörper (13) aus supraleitendem Material besteht, innerhalb des Heliumtankes (10) angeordnet und mit einer Einrichtung versehen ist, die es gestattet, den Abschirmkörper (13) während des Ladens der Magnetspule (12) auf einer über der kritischen Temperatur liegenden Temperatur zu halten.

5. Magnetanordnung nach Anspruch 4, dadurch gekennzeichnet, daß der Abschirmkörper (13) aus einem Gewebe aus supraleitenden Fasern besteht.

6. Magnetanordnung nach Anspruch 4, dadurch gekennzeichnet, daß der Abschirmkörper (13) aus einem dünnen Blech aus einer supraleitenden Legierung besteht, das eine Gitterstruktur aufweist.

7. Magnetanordnung nach Anspruch 5 oder 6, dadurch gekennzeichnet, daß der Durchmesser der Fasern bzw. der Stege der Gitterstruktur nicht größer ist als etwa 0,5 mm.

8. Magnetanordnung nach einem der vorhergehenden Ansprüche, dadurch gekennzeichnet, daß der Abschirmkörper (13) als ein selbsttragendes, innerhalb des Heliumtankes (10) angeordnetes Rohr ausgebildet ist.

9. Magnetanordnung nach Anspruch 8, dadurch gekennzeichnet, daß das den Abschirmkörper (13) bildende Rohr bei der Betriebstemperatur an der Innenseite des Tragrohres (11) der Magnetspule (12) fest anliegt.

10. Magnetanordnung nach einem der Ansprüche 1 bis 7, dadurch gekennzeichnet, daß der Abschirmkörper (13) von einer auf ein tragendes Rohr der Magnetanordnung, insbesondere auf die Außenseite der inneren Wand des Heliumtankes (10) oder auf die Innenseite des Tragrohres (11) für die Magnetspule (12), aufgebrachten Schicht aus einem Material extrem hoher Leitfähigkeit gebildet wird.

11. Magnetanordnung nach einem der vorhergehenden Ansprüche, dadurch gekennzeichnet, daß die innerhalb des Abschirmkörpers (13) angeordneten Rohre (1 bis 4) eine elektrische Leitfähigkeit von höchstens $5 \times 10^7$ Siemens/m und vorzugsweise von etwa $1,5 \times 10^6$ Siemens/m aufweisen.

12. Magnetanordnung nach einem der vorhergehenden Ansprüche, dadurch gekennzeichnet, daß wenigstens eines der innerhalb des Abschirmkörpers (13) angeordneten Rohre in seiner Längsrichtung geschlitzt ist.

13. Supraleitende Magnetanordnung für Kernspin-Tomographiegeräte mit einer aus supraleitendem Draht und einem Trägerrohr (11) bestehenden, im wesentlichen zylindrischen Magnetspule (12) zur Erzeugung eines Hauptfeldes, mit einem zur Magnetspule (12) koaxialen Kryostaten, der aus einer Anzahl von zu der Magnetspule (12) koaxialen, innerhalb und außerhalb der Magnetspule angeordneten, metallischen Rohren (1 bis 9) besteht, von denen wenigstens einige paarweise durch Endwände miteinander verbunden sind, wobei das äußerste (9) und das innerste Rohr (1) Bestandteile eines äußeren Mantels sind, und wobei die der Magnetspule (12) benachbarten Rohre (4, 5) die Wandungen eines die Magnetspule (12) umschließenden Heliumtankes (10) bilden und die übrigen Rohre (2, 3, 6-8) zwischen den Wandungen des Heliumtankes (10) und den Rohren des Mantels angeordnete Strahlungsschilde sind und gegebenenfalls die Wandungen (7, 8) eines die Magnetspule (12) umgebenden Stickstofftankes bilden, mit innerhalb des innersten Rohres angeordneten Gradientenspulen (14), mittels derer für die Tomographie geeignete, zeitlich veränderbare Feldgradienten erzeugbar sind, und mit einem zwischen dem innersten Rohr (1) und der Magnetspule (12) angeordneten, supraleitenden Abschirmkörper (13), dadurch gekennzeichnet, daß abgesehen vom Abschirmkörper (13) sämtliche Rohre (1 bis 9, 11) der Magnetanordnung aus einem elektrisch möglichst schlecht leitenden Material bestehen, und daß der Abschirmkörper (13) als ein System von im Heliumtank (10) des Kryostaten angeordneten, supraleitenden Abschirmspulen ausgebildet ist, die eine außenseitige Kompensation der von den Gradientenspulen erzeugten Magnetfelder bewirken, und deren grundsätzliche Geometrie derjenigen der jeweils zugeordneten Gradientenspulen ähnlich ist, wobei jede der Abschirmspulen einen geschlossenen supraleitenden Stromkreis bildet, der mittels eines supraleitenden Schalters absperrbar bzw. schließbar ist, so daß sich im geschlossenen Zustand der Schalter die in den Abschirmspulen fließenden Ströme induktiv auf den eine optimale Abschirmung vermittelnden Betrag einstellen.

**14.** Magnetanordnung nach Anspruch 13, dadurch gekennzeichnet, daß die Abschirmspulen mit Gleichstrom ladbar sind.

**Patentansprüche für folgende Vertragsstaaten : DE, GB**

**1.** Supraleitende Magnetanordnung, insbesondere für Kernspin-Tomographiegeräte, mit einer aus supraleitendem Draht und einem Trägerrohr (11) bestehenden, im wesentlichen zylindrischen Magnetspule (12), mit einem zur Magnetspule (12) koaxialen Kryostat, der aus einer Anzahl von zur Magnetspule (12) koaxialen, innerhalb und außerhalb der Magnetspule (12) angeordneten metallischen Rohren (1 bis 9) besteht, von denen wenigstens einige paarweise durch Endwände miteinander verbunden sind, wobei das äußerste (9) und das innerste Rohr (1) Bestandteile eines äußeren Mantels sind, und wobei die der Magnetspule (12) benachbarten Rohre (4, 5) die Wandungen eines die Magnetspule (12) umschließenden Heliumtankes (10) bilden und die übrigen Rohre (2, 3, 6-8) zwischen den Wandungen des Heliumtankes (10) und den Rohren des Mantels angeordnete Strahlungsschilde sind und gegebenenfalls die Wandungen (7, 8) eines die Magnetspule (12) umgebenden Stickstofftankes bilden, mit innerhalb des innersten Rohres angeordneten Gradientspulen (14), mittels derer für die Tomographie geeignete, zeitlich veränderbare Feldgradienten erzeugbar sind, und mit einem zwischen dem innersten Rohr (1) und der Magnetspule (12) angeordneten zylindrischen, der Abschirmung der Gradientenfelder nach außen dienenden Abschirmkörper (13), dessen dem Produkt aus seiner elektrischen Leitfähigkeit und seiner Wandstärke gleiche elektrische Leitzahl erheblich größer ist als die Leitzahl der weiter außen liegenden Rohre, dadurch gekennzeichnet, daß der Abschirmkörper (13) in engem thermischen Kontakt mit dem Heliumtank (10) angeordnet ist, daß dieser Körper aus einem elektrisch sehr gut leitenden, bei Betriebstemperatur resistiven Material mit einer Wandstärke von höchstens 10 mm besteht, und daß alle anderen Rohre (1 bis 9, 11) der Magnetanordnung innerhalb und außerhalb des Abschirmkörpers (13) aus einem im Vergleich mit der elektrischen Leitfähigkeit des Abschirmkörpers (13) elektrisch schlecht leitendem Material bestehen, derart, daß bei Betriebstemperatur der Magnetanordnung die Leitzahl des Abschirmkörpers (13) wenigstens das Zehnfache der Leitzahlen sowohl der außerhalb als auch der innerhalb des Abschirmkörpers liegenden Rohre (1 bis 9, 11) beträgt.

**2.** Magnetanordnung nach Anspruch 1, dadurch gekennzeichnet, daß die elektrische Leitfähigkeit des Abschirmkörpers (13) bei der Betriebstemperatur größer ist als $10^9$ Siemens/m.

**3.** Magnetanordnung nach Anspruch 1 oder 2, dadurch gekennzeichnet, daß der Abschirmkörper (13) aus hochreinem Aluminium besteht.

**4.** Magnetanordnung nach Anspruch 1, dadurch gekennzeichnet, daß der Abschirmkörper (13) statt aus resistivem Material aus einem Gewebe aus supraleitenden Fasern besteht, und daß der Abschirmkörper (13) innerhalb des Heliumtanks (10) angeordnet und mit einer Einrichtung versehen ist, die es gestattet, den Abschirmkörper (13) während des Ladens der Magnetspule (12) auf einer über der kritischen Temperatur liegenden Temperatur zu halten.

**5.** Magnetanordnung nach Anspruch 1, dadurch gekennzeichnet, daß der Abschirmkörper (13) statt aus resistivem Material aus einem dünnen Blech aus einer supraleitenden Legierung besteht, das eine Gitterstruktur aufweist, und daß der Abschirmkörper (13) innerhalb des Heliumtanks (10) angeordnet und mit einer Einrichtung versehen ist, die es gestattet, den Abschirmkörper (13) während des Ladens der Magnetspule (12) auf einer über der kritischen Temperatur liegenden Temperatur zu halten.

**6.** Magnetanordnung nach Anspruch 4 oder 5, dadurch gekennzeichnet, daß der Durchmesser der Fasern bzw. der Stege der Gitterstruktur nicht größer ist als etwa 0,5 mm.

**7.** Magnetanordnung nach einem der vorhergehenden Ansprüche, dadurch gekennzeichnet, daß der Abschirmkörper (13) als ein selbsttragendes, innerhalb des Heliumtankes (10) angeordnetes Rohr ausgebildet ist.

**8.** Magnetanordnung nach Anspruch 7, dadurch gekennzeichnet, daß das den Abschirmkörper (13) bildende Rohr bei der Betriebstemperatur an der Innenseite des Tragrohres (11) der Magnetspule (12) fest anliegt.

9. Magnetanordnung nach einem der Ansprüche 1 bis 6, dadurch gekennzeichnet, daß der Abschirmkörper (13) von einer auf ein tragendes Rohr der Magnetanordnung, insbesondere auf die Außenseite der inneren Wand des Heliumtankes (10) oder auf die Innenseite des Tragrohres (11) für die Magnetspule (12), aufgebrachten Schicht aus einem Material extrem hoher Leitfähigkeit gebildet wird.

10. Magnetanordnung nach einem der vorhergehenden Ansprüche, dadurch gekennzeichnet, daß die innerhalb des Abschirmkörpers (13) angeordneten Rohre (1 bis 4) eine elektrische Leitfähigkeit von höchstens $5 \times 10^7$ Siemens/m und vorzugsweise von etwa $1,5 \times 10^6$ Siemens/m aufweisen.

11. Magnetanordnung nach einem der vorhergehenden Ansprüche, dadurch gekennzeichnet, daß wenigstens eines der innerhalb des Abschirmkörpers (13) angeordneten Rohre in seiner Längsrichtung geschlitzt ist.

12. Supraleitende Magnetanordnung für Kernspin-Tomographiegeräte mit einer aus supraleitendem Draht und einem Trägerrohr (11) bestehenden, im wesentlichen zylindrischen Magnetspule (12) zur Erzeugung eines Hauptfeldes, mit einem zur Magnetspule (12) koaxialen Kryostaten, der aus einer Anzahl von zu der Magnetspule (12) koaxialen, innerhalb und außerhalb der Magnetspule angeordneten, metallischen Rohren (1 bis 9) besteht, von denen wenigstens einige paarweise durch Endwände miteinander verbunden sind, wobei das äußerste (9) und das innerste Rohr (1) Bestandteile eines äußeren Mantels sind, und wobei die der Magnetspule (12) benachbarten Rohre (4, 5) die Wandungen eines die Magnetspule (12) umschließenden Heliumtankes (10) bilden und die übrigen Rohre (2, 3, 6-8) zwischen den Wandungen des Heliumtankes (10) und den Rohren des Mantels angeordnete Strahlungsschilde sind und gegebenenfalls die Wandungen (7, 8) eines die Magnetspule (12) umgebenden Stickstofftankes bilden, mit innerhalb des innersten Rohres angeordneten Gradientenspulen (14), mittels derer für die Tomographie geeignete, zeitlich veränderbare Feldgradienten erzeugbar sind, und mit einem zwischen dem innersten Rohr (1) und der Magnetspule (12) angeordneten, supraleitenden Abschirmkörper (13), dadurch gekennzeichnet, daß abgesehen vom Abschirmkörper (13) sämtliche Rohre (1 bis 9, 11) der Magnetanordnung aus einem elektrisch möglichst schlecht leitenden Material bestehen, und daß der Abschirmkörper (13) als ein System von im Heliumtank (10) des Kryostaten angeordneten, supraleitenden Abschirmspulen ausgebildet ist, die eine außenseitige Kompensation der von den Gradientenspulen erzeugten Magnetfelder bewirken, und deren grundsätzliche Geometrie derjenigen der jeweils zugeordneten Gradientenspulen ähnlich ist, wobei jede der Abschirmspulen einen geschlossenen supraleitenden Stromkreis bildet, der mittels eines supraleitenden Schalters absperrbar bzw. schließbar ist, so daß sich im geschlossenen Zustand der Schalter die in den Abschirmspulen fließenden Ströme induktiv auf den eine optimale Abschirmung vermittelnden Betrag einstellen.

13. Magnetanordnung nach Anspruch 12, dadurch gekennzeichnet, daß die Abschirmspulen mit Gleichstrom ladbar sind.

## Claims

### Claims for the following Contracting States : FR, NL

1. Superconducting magnet arrangement, especially for nuclear spin tomographic apparatus, with an essentially cylindrical magnet coil (12) consisting of superconducting wire and a support tube (11), with a cryostat, coaxial with the magnet coil (12), consisting of a number of metal tubes (1 to 9) coaxial with the magnet coil (12) and located inside and outside the magnet coil (12), of which at least a few are connected together in pairs by end partitions, wherein the outermost tube (9) and the innermost tube (1) are components of an outer casing, and wherein the tubes (4, 5) adjacent to the magnet coil (12) form the walls of a helium tank (10) surrounding the magnet coil (12), and the remaining tubes (2, 3, 6-8) are radiation barriers located between the walls of the helium tank (10) and the tubes of the casing, and possibly form the walls (7, 8) of a nitrogen tank surrounding the magnet coil (12); with gradient coils (14) located inside the innermost tube by means of which the time-varying field gradients suitable for tomography can be generated and with a cylindrical shield (13) located between the innermost tube (1) and the magnet coil (12) and serving for shielding the gradient fields to the exterior, whose electrical conductance, equal to the product of its electrical conductivity times its wall thickness, is considerably greater than the conductance of the tubes located farther out, characterized in that the shield (13) is in close thermal contact with the helium tank (10), that this shield is made of an electrically very highly conductive material which has a wall thickness of no more than 10 mm and that all other tubes (1 to 9, 11) of the magnet arrangement inside and outside of the shield (13) are made of an electrically poorly conductive material compared to the electrical conductivity of the shield (13) so that at the operating temperature of the magnet arrangement the conductance of the shield (13) is at least ten times the conductance of the tubes (1 to 9, 11) located both outside and inside the shield.

2. Magnet arrangement according to claim 1, characterized in that the electrical conductivity of the shield (13) is greater than $10^9$ siemens/m at the operating temperature.

3. Magnet arrangement according to claim 1 or 2, characterized in that the shield (13) is made of high-purity aluminum.

4. Magnet arrangement according to claim 1, characterized in that the shield (13) is made of superconducting material, is located inside the helium tank (10), and is provided with a device making it possible to keep the shield (13) at a temperature above the critical temperature during energization of the magnet coil (12).

5. Magnet arrangement according to claim 4, characterized in that the shield (13) consists of a fabric made of superconducting fibers.

6. Magnet arrangement according to claim 4, characterized in that the shield (13) consists of a thin sheet made of a superconducting alloy which has a grid structure.

7. Magnet arrangement according to claim 5 or 6, characterized in that the diameter of the fibers and of the members of the grid structure, respectively, is not greater than approximately 0.5 mm.

8. Magnet arrangement according to any of the preceding claims, characterized in that the shield (13) is configured as a self-supporting tube located inside the helium tank (10).

9. Magnet arrangement according to claim 8, characterized in that at operating temperature, the tube constituting the shield (13) is in close contact with the inside of the support tube (11) of the magnet coil (12).

10. Magnet arrangement according to any of claims 1 to 7, characterized in that the shield (13) consists of a coating of a material with extremely high conductivity, applied onto a supporting tube of the magnet arrangement, especially onto the outside of the inner wall of the helium tank (10) or onto the inside of the support tube (11) for the magnet coil (12).

11. Magnet arrangement according to any of the preceding claims, characterized in that the tubes (1 to 4) located inside the shield (13) have an electrical conductivity of not more than $5 \times 10^7$ siemens/m, and preferably of approximately $1.5 \times 10^6$ siemens/m.

12. Magnet arrangement according to any of the preceding claims, characterized in that at least one of the tubes located inside the shield (13) is slit longitudinally.

13. Superconducting magnet arrangement for nuclear spin tomographic apparatus, with an essentially cylindrical magnet coil (12), consisting of superconducting wire and a support tube (11), for generating a main field; with a cryostat, coaxial with the magnet coil (12), consisting of a number of metal tubes (1 to 9) coaxial with the magnet coil (12) and located inside and outside the magnet coil, of which at least a few are connected together in pairs by end partitions, wherein the outermost tube (9) and the innermost tube (1) are components of an outer casing and wherein the tubes (4, 5) adjacent to the magnet coil (12) constituting the walls of a helium tank (10) enclosing the magnet coil (12) and the remaining tubes (2, 3, 6-8) are radiation barriers located between the walls of the helium tank (10) and the tubes of the casing, and possibly constitute the walls (7, 8) of a nitrogen tank enclosing the magnet coil (12); with gradient coils (14) located inside the innermost tube by means of which time-varying field gradients suitable for tomography can be generated; and with a superconducting shield (13) located between the innermost tube (1) and the magnet coil (12), characterized in that, except for the shield (13), all tubes (1 to 9, 11) of the magnet arrangement are made of a material which conducts electricity as poorly as possible and that the shield (13) is configured as a system of superconducting shielding coils located in the helium tank (10) of the cryostat which provide an external compensation for the magnetic fields generated by the gradient coils and the basic geometry of which is similar to the one of the respectively allocated gradient coils, wherein each of the shielding coils constitutes a self-contained superconducting electric circuit which can be blocked or closed by means of a superconducting switch so that in the closed state of the switches the currents flowing in the shielding coils adjust inductively to the value providing optimum shielding.

14. Magnet arrangement according to claim 13, characterized in that the shielding coils can be energized with direct current.

**Claims for the following Contracting States : DE, GB**

1. Superconducting magnet arrangement, especially for nuclear spin tomographic apparatus, with an essentially cylindrical magnet coil (12) consisting of superconducting wire and a support tube (11), with a cryostat, coaxial with the magnet coil (12), consisting of a number of metal tubes (1 to 9) coaxial with the magnet coil (12) and located inside and outside the magnet coil (12), of which at least a few are connected together in pairs by end partitions, wherein the outermost tube (9) and the innermost tube (1) are components of an outer casing, and wherein the tubes (4, 5) adjacent to the magnet coil (12) form the walls of a helium tank (10) surrounding the magnet coil (12), and the remaining tubes (2, 3, 6-8) are radiation barriers located between the walls of the helium tank (10) and the tubes of the casing, and possibly form the walls (7, 8) of a nitrogen tank surrounding the magnet coil (12); with gradient coils (14) located inside the innermost tube by means of which the time-varying field gradients suitable for tomography can be generated and with a cylindrical shield (13) located between the innermost tube (1) and the magnet coil (12) and serving for shielding the gradient fields to the exterior, whose electrical conductance, equal to the product of its electrical conductivity times its wall thickness, is considerably greater than the conductance of the tubes located farther out, characterized in that the shield (13) is in close thermal contact with the helium tank (10), that this shield is made of an electrically very highly conductive material which is resistive at the operating temperature and has a wall thickness of no more than 10 mm and that all other tubes (1 to 9, 11) of the magnet arrangement inside and outside of the shield (13) are made of an electrically poorly conductive material compared to the electrical conductivity of the shield (13) so that at the operating temperature of the magnet arrangement the conductance of the shield (13) is at least ten times the conductance of the tubes (1 to 9, 11) located both outside and inside the shield.

2. Magnet arrangement according to claim 1, characterized in that the electrical conductivity of the shield (13) is greater than $10^9$ siemens/m at the operating temperature.

3. Magnet arrangement according to claim 1 or 2, characterized in that the shield (13) is made of high-purity aluminum.

4. Magnet arrangement according to claim 1, characterized in that the shield (13) consists of a fabric made of superconducting fibers instead of resistive material and that the shield (13) is located inside the helium tank (10) and is provided with a device making it possible to keep the shield (13) at a temperature above the critical temperature during energization of the magnet coil (12).

5. Magnet arrangement according to claim 1, characterized in that, instead of resistive material, the shield (13) consists of a thin sheet made of a superconducting alloy which has a grid structure and that the shield (13) is located inside the helium tank (10) and is provided with a device making it possible to keep the shield (13) at a temperature above the critical temperature during energization of the magnet coil (12).

6. Magnet arrangement according to claim 4 or 5, characterized in that the diameter of the fibers and of the members of the grid structure, respectively, is not greater than approximately 0.5 mm.

7. Magnet arrangement according to any of the preceding claims, characterized in that the shield (13) is configured as a self-supporting tube located inside the helium tank (10).

8. Magnet arrangement according to claim 7, characterized in that at operating temperature, the tube constituting the shield (13) is in close contact with the inside of the support tube (11) of the magnet coil (12).

9. Magnet arrangement according to any of claims 1 to 6, characterized in that the shield (13) consists of a coating of a material with extremely high conductivity, applied onto a supporting tube of the magnet arrangement, especially onto the outside of the inner wall of the helium tank (10) or onto the inside of the support tube (11) for the magnet coil (12).

10. Magnet arrangement according to any of the preceding claims, characterized in that the tubes (1 to 4) located inside the shield (13) have an electrical conductivity of not more than 5 x $10^7$ siemens/m, and preferably of approximately 1.5 x $10^6$ siemens/m.

11. Magnet arrangement according to any of the preceding claims, characterized in that at least one of the tubes located inside the shield (13) is slit longitudinally.

12. Superconducting magnet arrangement for nuclear spin tomographic apparatus, with an essentially cylindrical magnet coil (12), consisting of superconducting wire and a support tube (11), for generating a main field; with a cryostat, coaxial with the magnet coil (12), consisting of a number of metal tubes (1 to 9) coaxial with the magnet coil (12) and located inside and outside the magnet coil, of which at least a few are connected together in pairs by end partitions, wherein the outermost tube (9) and the innermost tube (1) are components of an outer casing and wherein the tubes (4, 5) adjacent to the magnet coil (12) constituting the walls of a helium tank (10) enclosing the magnet coil (12) and the remaining tubes (2, 3, 6-8) are radiation barriers located between the walls of the helium tank (10) and the tubes of the casing, and possibly constitute the walls (7, 8) of a nitrogen tank enclosing the magnet coil (12); with gradient coils (14) located inside the innermost tube by means of which time-varying field gradients suitable for tomography can be generated; and with a superconducting shield (13) located between the innermost tube (1) and the magnet coil (12), characterized in that, except for the shield (13), all tubes (1 to 9, 11) of the magnet arrangement are made of a material which conducts electricity as poorly as possible and that the shield (13) is configured as a system of superconducting shielding coils located in the helium tank (10) of the cryostat which provide an external compensation for the magnetic fields generated by the gradient coils and the basic geometry of which is similar to the one of the respectively allocated gradient coils, wherein each of the shielding coils constitutes a self-contained superconducting electric circuit which can be blocked or closed by means of a superconducting switch so that in the closed state of the switches the currents flowing in the shielding coils adjust inductively to the value providing optimum shielding.

13. Magnet arrangement according to claim 12, characterized in that the shielding coils can be energized with direct current.

**Revendications**

**Revendications pour les Etats contractants suivants : FR, NL**

1. Structure d'aimant supraconducteur, en particulier pour des appareils de tomographie par résonance magnétique nucléaire, comprenant une bobine magnétique (12), pour l'essentiel cylindrique, qui est constituée par du fil supraconducteur et par un tube porteur (11), comprenant un cryostat coaxial par rapport à la bobine magnétique (12) et constitué par une pluralité de tubes métalliques (1 à 9) qui sont coaxiaux par rapport à la bobine magnétique (12), qui sont disposés à l'intérieur et à l'extérieur de la bobine magnétique (12) et dont quelques-uns au moins sont reliés entre eux par paires par des parois d'extrémité, cependant que le tube (9) qui est situé le plus à l'extérieur et le tube (1) qui est situé le plus à l'intérieur sont des constituants d'une enveloppe extérieure, que les tubes (4, 5) qui sont contigus à la bobine magnétique (12) forment les parois d'un réservoir d'hélium (10) entourant la bobine magnétique (12) et que les autres tubes (2, 3, 6 à 8) sont des écrans protégeant des rayonnements qui sont disposés entre les parois du réservoir d'hélium (10) et les tubes de l'enveloppe en formant éventuellement les parois (7, 8) d'un réservoir d'azote qui entoure la bobine magnétique (12), comprenant des bobines à champ variable (14) disposées à l'intérieur du tube qui est situé le plus à l'intérieur, au moyen desquelles peuvent être engendrés des champs variables qui conviennent à la tomographie et qui peuvent être modifiés dans le temps, et comprenant un corps cylindrique formant écran (13) qui est disposé entre le tube (1) situé le plus à l'intérieur et la bobine magnétique (12), qui sert à former pour les champs variables un écran par rapport à l'extérieur et dont la conductance électrique, laquelle est égale au produit de sa conductivité électrique par l'épaisseur de sa paroi, est nettement plus élevée que la conductance des autres tubes situés vers l'extérieur, caractérisée par le fait que le corps formant écran (13) est disposé en contact thermique étroit avec le réservoir d'hélium (10), par le fait que ce corps est constitué par une matière très bonne conductrice de l'électricité, l'épaisseur de sa paroi étant de 10 mm au plus, et par le fait que tous les autres tubes (1 à 9, 11) de la structure d'aimant à l'intérieur et à l'extérieur du corps formant écran (13) sont constitués par une matière qui est mauvaise conductrice de l'électricité en comparaison de la conductibilité électrique du corps formant écran (13), et ce, d'une manière telle qu'à la température de fonctionnement de la structure d'aimant, la conductance du corps formant écran (13) soit au moins le décuple des conductances des tubes (1 à 9, 11) qui sont situés tant à l'extérieur qu'à l'intérieur du corps formant écran.

2. Structure d'aimant selon la revendication 1, caractérisée par le fait que la conductivité électrique du corps formant écran (13) est supérieure à $10^9$ Siemens/m à la température de fonctionnement.

3. Structure d'aimant selon la revendication 1 ou 2, caractérisée par le fait que le corps formant écran (13) est en aluminium de haute pureté.

4. Structure d'aimant selon la revendication 1 ou 2, caractérisée par le fait que le corps formant écran (13) est constitué par un matériau supraconducteur, qu'il est disposé à l'intérieur du réservoir d'hélium (10), et qu'il est pourvu d'un dispositif qui permet de maintenir le corps formant écran (13) à une température située au-dessus de la température critique pendant la charge de la bobine magnétique (12).

5. Structure d'aimant selon la revendication 4, caractérisée par le fait que le corps formant écran (13) est constitué par un tissu de fibres supraconductrices.

6. Structure d'aimant selon la revendication 4, caractérisée par le fait que le corps formant écran (13) est constitué par une tôle mince en alliage supraconducteur qui présente la structure d'une grille.

7. Structure d'aimant selon la revendication 5 ou 6, caractérisée par le fait que le diamètre des fibres ou, respectivement, des tiges de la structure en grille n'est pas supérieur à 0,5 mm environ.

8. Structure d'aimant selon l'une des revendications précédentes, caractérisée par le fait que le corps formant écran (13) est réalisé sous la forme d'un tube indépendant disposé à l'intérieur du réservoir d'hélium (10).

9. Structure d'aimant selon la revendication 8, caractérisée par le fait qu'à la température de fonctionnement, le tube qui constitue le corps formant écran (13) s'appuie fortement sur le côté intérieur du tube porteur (11) de la bobine magnétique (12).

10. Structure d'aimant selon l'une des revendications 1 à 7, caractérisée par le fait que le corps formant écran (13) est constitué par une couche d'un matériau dont la conductivité est extrêmement élevée, cette couche étant en particulier appliquée sur le côté extérieur de la paroi intérieure du réservoir d'hélium (10) ou sur le côté intérieur du tube porteur (11) destiné à la bobine magnétique (12).

11. Structure d'aimant selon l'une des revendications précédentes, caractérisée par le fait que les tubes (1 à 4) qui sont disposés à l'intérieur du corps formant écran (13) présentent une conductivité électrique de $5 \times 10^7$ Siemens/m au plus, et de préférence de $1,5 \times 10^6$ Siemens/m environ.

12. Structure d'aimant selon l'une des revendications précédentes, caractérisée par le fait qu'au moins l'un des tubes qui sont disposés à l'intérieur du corps formant écran (13) est fendu dans sa direction longitudinale.

13. Structure d'aimant supraconducteur, pour des appareils de tomographie par résonance magnétique nucléaire, comprenant une bobine magnétique (12), pour l'essentiel cylindrique, qui est constituée par du fil supraconducteur et par un tube porteur (11) et qui est destinée à engendrer un champ principal, comprenant un cryostat coaxial par rapport à la bobine magnétique (12) et constitué par une pluralité de tubes métalliques (1 à 9) qui sont coaxiaux par rapport à la bobine magnétique (12), qui sont disposés à l'intérieur et à l'extérieur de la bobine magnétique et dont quelques-uns au moins sont reliés entre eux par paires par des parois d'extrémité, cependant que le tube (9) qui est situé le plus à l'extérieur et le tube (1) qui est situé le plus à l'intérieur sont des constituants d'une enveloppe extérieure, que les tubes (4, 5) qui sont contigus à la bobine magnétique (12) forment les parois d'un réservoir d'hélium (10) entourant la bobine magnétique (12) et que les autres tubes (2, 3, 6 à 8) sont des écrans protégeant des rayonnements qui sont disposés entre les parois du réservoir d'hélium (10) et les tubes de l'enveloppe en formant éventuellement les parois (7, 8) d'un réservoir d'azote qui entoure la bobine magnétique (12), comprenant des bobines à champ variable (14) disposées à l'intérieur du tube qui est situé le plus à l'intérieur, au moyen desquelles peuvent être engendrés des champs variables qui conviennent à la tomographie et qui peuvent être modifiés dans le temps, et comprenant un corps supraconducteur formant écran (13) qui est disposé entre le tube (1) situé le plus à l'intérieur et la bobine magnétique (12), caractérisée par le fait que, mis à part le corps formant écran (13), l'ensemble des tubes (1 à 9, 11) de la structure d'aimant est constitué par un matériau aussi mauvais conducteur de l'électricité que possible, et par le fait que le corps formant écran (13) est réalisé sous la forme d'un système de bobines supraconductrices formant écran qui sont disposées à l'intérieur du réservoir d'hélium (10) du cryostat, qui produisent une compensation extérieure des champs magnétiques engendrés par les bobines à champ variable et dont la géométrie de base est analogue à celle des bobines à champ variable à chaque fois associées, cependant que chacune des bobines formant écran forme un circuit de courant supraconducteur fermé qui peut être bloqué ou fermé, respectivement, au moyen d'un cryotron, de sorte qu'à l'état fermé du cryotron, les courants qui parcourent les bobines formant écran se règlent par induction sur la valeur procurant un effet d'écran optimal.

14. Structure d'aimant selon la revendication 13, caractérisée par le fait que les bobines formant écran peuvent être chargées au moyen d'un courant continu.

**Revendications pour les Etats contractants suivants : DE, GB**

1. Structure d'aimant supraconducteur, en particulier pour des appareils de tomographie par résonance magnétique nucléaire, comprenant une bobine magnétique (12), pour l'essentiel cylindrique, qui est constituée par du fil supraconducteur et par un tube porteur (11), comprenant un cryostat coaxial par rapport à la bobine magnétique (12) et constitué par une. pluralité de tubes métalliques (1 à 9) qui sont coaxiaux par rapport à la bobine magnétique (12), qui sont disposés à l'intérieur et à l'extérieur de la bobine magnétique (12) et dont quelques-uns au moins sont reliés entre eux par paires par des parois d'extrémité, cependant que le tube (9) qui est situé le plus à l'extérieur et le tube (1) qui est situé le plus à l'intérieur sont des constituants d'une enveloppe extérieure, que les tubes (4, 5) qui sont contigus à la bobine magnétique (12) forment les parois d'un réservoir d'hélium (10) entourant la bobine magnétique (12) et que les autres tubes (2, 3, 6 à 8) sont des écrans protégeant des rayonnements qui sont disposés entre les parois du réservoir d'hélium (10) et les tubes de l'enveloppe en formant éventuellement les parois (7, 8) d'un réservoir d'azote qui entoure la bobine magnétique (12), comprenant des bobines à champ variable (14) disposées à l'intérieur du tube qui est situé le plus à l'intérieur, au moyen desquelles peuvent être engendrés des champs variables qui conviennent à la tomographie et qui peuvent être modifiés dans le temps, et comprenant un corps cylindrique formant écran (13) qui est disposé entre le tube (1) situé le plus à l'intérieur et la bobine magnétique (12), qui sert à former pour les champs variables un écran par rapport à l'extérieur et dont la conductance électrique, laquelle est égale au produit de sa conductivité électrique par l'épaisseur de sa paroi, est nettement plus élevée que la conductance des autres tubes situés vers l'extérieur, caractérisée par le fait que le corps formant écran (13) est disposé en contact thermique étroit avec le réservoir d'hélium (10), par le fait que ce corps est constitué par une matière très bonne conductrice de l'électricité, l'épaisseur de sa paroi étant de 10 mm au plus, et par le fait que tous les autres tubes (1 à 9, 11) de la structure d'aimant à l'intérieur et à l'extérieur du corps formant écran (13) sont constitués par une matière qui est mauvaise conductrice de l'électricité en comparaison de la conductibilité électrique du corps formant écran (13), et ce, d'une manière telle qu'à la température de fonctionnement de la structure d'aimant, la conductance du corps formant écran (13) soit au moins le décuple des conductances des tubes (1 à 9, 11) qui sont situés tant à l'extérieur qu'à l'intérieur du corps formant écran.

2. Structure d'aimant selon la revendication 1, caractérisée par le fait que la conductivité électrique du corps formant écran (13) est supérieure à $10^9$ Siemens/m à la température de fonctionnement.

3. Structure d'aimant selon la revendication 1 ou 2, caractérisée par le fait que le corps formant écran (13) est en aluminium de haute pureté.

4. Structure d'aimant selon la revendication 1, caractérisée par le fait que le corps formant écran (13), au lieu d'être constitué par un matériau résistant, l'est par un tissu de fibres supraconductrices, et par le fait que le corps formant écran (13) est disposé à l'intérieur du réservoir d'hélium (10), et qu'il est pourvu d'un dispositif qui permet de maintenir le corps formant écran (13) à une température située au-dessus de la température critique pendant la charge de la bobine magnétique (12).

5. Structure d'aimant selon la revendication 1, caractérisée par le fait que le corps formant écran (13), au lieu d'être constitué par un matériau résistant, l'est par une tôle mince en alliage supraconducteur qui présente la structure d'une grille, et par le fait que le corps formant écran (13) est disposé à l'intérieur du réservoir d'hélium (10), et qu'il est pourvu d'un dispositif qui permet de maintenir le corps formant écran (13) à une température située au-dessus de la température critique pendant la charge de la bobine magnétique (12).

6. Structure d'aimant selon la revendication 4 ou 5, caractérisée par le fait que le diamètre des fibres ou, respectivement, des tiges de la structure en grille n'est pas supérieur à 0,5 mm environ.

7. Structure d'aimant selon l'une des revendications précédentes, caractérisée par le fait que le corps formant écran (13) est réalisé sous la forme d'un tube indépendant disposé à l'intérieur du réservoir d'hélium (10).

8. Structure d'aimant selon la revendication 7, caractérisée par le fait qu'à la température de fonctionnement, le tube qui constitue le corps formant écran (13) s'appuie fortement sur le côté intérieur du tube porteur (11) de la bobine magnétique (12).

9. Structure d'aimant selon l'une des revendications 1 à 6, caractérisée par le fait que le corps formant écran (13) est constitué par une couche d'un matériau dont la conductivité est extrêmement élevée, cette couche étant en particulier appliquée sur le côté extérieur de la paroi intérieure du réservoir d'hélium (10) ou sur le côté intérieur du tube porteur (11) destiné à la bobine magnétique (12).

10. Structure d'aimant selon l'une des revendications précédentes, caractérisée par le fait que les tubes (1 à 4) qui sont disposés à l'intérieur du corps formant écran (13) présentent une conductivité électrique de $5 \times 10^7$ Siemens/m au plus, et de préférence de $1,5 \times 10^6$ Siemens/m environ.

11. Structure d'aimant selon l'une des revendications précédentes, caractérisée par le fait qu'au moins l'un des tubes qui sont disposés à l'intérieur du corps formant écran (13) est fendu dans sa direction longitudinale.

12. Structure d'aimant supraconducteur, pour des appareils de tomographie par résonance magnétique nucléaire, comprenant une bobine magnétique (12), pour l'essentiel cylindrique, qui est constituée par du fil supraconducteur et par un tube porteur (11) et qui est destinée à engendrer un champ principal, comprenant un cryostat coaxial par rapport à la bobine magnétique (12) et constitué par une pluralité de tubes métalliques (1 à 9) qui sont coaxiaux par rapport à la bobine magnétique (12), qui sont disposés à l'intérieur et à l'extérieur de la bobine magnétique et dont quelques-uns au moins sont reliés entre eux par paires par des parois d'extrémité, cependant que le tube (9) qui est situé le plus à l'extérieur et le tube (1) qui est situé le plus à l'intérieur sont des constituants d'une enveloppe extérieure, que les tubes (4, 5) qui sont contigus à la bobine magnétique (12) forment les parois d'un réservoir d'hélium (10) entourant la bobine magnétique (12) et que les autres tubes (2, 3, 6 à 8) sont des écrans protégeant des rayonnements qui sont disposés entre les parois du réservoir d'hélium (10) et les tubes de l'enveloppe en formant éventuellement les parois (7, 8) d'un réservoir d'azote qui entoure la bobine magnétique (12), comprenant des bobines à champ variable (14) disposées à l'intérieur du tube qui est situé le plus à l'intérieur, au moyen desquelles peuvent être engendrés des champs variables qui conviennent à la tomographie et qui peuvent être modifiés dans le temps, et comprenant un corps supraconducteur formant écran (13) qui est disposé entre le tube (1) situé le plus à l'intérieur et la bobine magnétique (12), caractérisée par le fait que, mis à part le corps formant écran (13), l'ensemble des tubes (1 à 9, 11) de la structure d'aimant est constitué par un matériau aussi mauvais conducteur de l'électricité que possible, et par le fait que le corps formant écran (13) est réalisé sous la forme d'un système de bobines supraconductrices formant écran qui sont disposées à l'intérieur du réservoir d'hélium (10) du cryostat, qui produisent une compensation extérieure des champs magnétiques engendrés par les bobines à champ variable et dont la géométrie de base est analogue à celle des bobines à champ variable à chaque fois associées, cependant que chacune des bobines formant écran forme un circuit de courant supraconducteur fermé qui peut être bloqué ou fermé, respectivement, au moyen d'un cryotron, de sorte qu'à l'état fermé du cryotron, les courants qui parcourent les bobines formant écran se règlent par induction sur la valeur procurant un effet d'écran optimal.

13. Structure d'aimant selon la revendication 12, caractérisée par le fait que les bobines formant écran peuvent être chargées au moyen d'un courant continu.

EP 0 453 454 B1

Fig. 2

Fig. 1

21

Fig. 3

Fig. 4

Fig. 5